(19) Europäisches Patentamt / European Patent Office / Office européen des brevets

(11) **EP 3 216 841 A1**

(12) **EUROPEAN PATENT APPLICATION**
published in accordance with Art. 153(4) EPC

(43) Date of publication:
**13.09.2017 Bulletin 2017/37**

(21) Application number: **15857237.0**

(22) Date of filing: **04.11.2015**

(51) Int Cl.:
**C09K 11/79** (2006.01)    **C09K 11/59** (2006.01)
**H01L 33/50** (2010.01)

(86) International application number:
**PCT/JP2015/080994**

(87) International publication number:
**WO 2016/072407 (12.05.2016 Gazette 2016/19)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **05.11.2014   JP 2014225334**

(71) Applicant: UBE Industries, Ltd.
**Ube-shi, Yamaguchi 755-8633 (JP)**

(72) Inventors:
• **AMAGAI, Jin**
 **Ube-shi**
 **Yamaguchi 755-8510 (JP)**
• **FUKUDA, Kouichi**
 **Ube-shi**
 **Yamaguchi 755-8510 (JP)**
• **SAKAGUCHI, Tatsunori**
 **Ube-shi**
 **Yamaguchi 755-8510 (JP)**

(74) Representative: **Michalski Hüttermann & Partner Patentanwälte mbB**
 **Speditionstraße 21**
 **40221 Düsseldorf (DE)**

(54) **PHOSPHOR AND LIGHT-EMITTING DEVICE**

(57)    Provided is a phosphor represented by a composition of the following formula (1),

$$(Sr_a,Ba_b,Ca_c,Eu_x,M^1{}_d,M^2{}_e)SiO_f{\cdot}gMgO \cdots \qquad \text{formula (1)}$$

(here, $M^1$ represents at least one group 3 element selected from Lu and Sc, $M^2$ represents an alkali metal element selected from Li, Na, and K, and $0 < a \leq 2$, $0 < b \leq 2$, $0 \leq c \leq 2$, $0.0015 \leq d \leq 0.045$, $0 \leq e \leq 0.06$, $0 < x \leq 0.1$, $3.7 \leq f \leq 4.1$, and $0 \leq g \leq 1$ are satisfied). In addition, provided is a light-emitting device including the phosphor and a light source for irradiating the phosphor with excitation light to cause the phosphor to emit light.

EP 3 216 841 A1

**Description**

Technical Field

The present invention relates to a phosphor and a light-emitting device, and particularly to a silicate-based phosphor and a light-emitting device using the same.

Background Art

Conventionally, a two-color mixed type white LED to obtain white light by mixing blue and yellow in combination of a semiconductor light-emitting element emitting blue light and a yellow phosphor has been widely used. However, white light emitted by the two-color mixed type white LED has a low purity disadvantageously. Therefore, recently, a three-color mixed type white LED to obtain white light by mixing blue, green, and red by exciting three types of blue, green, and red phosphors with light emitted by a semiconductor light-emitting element to emit ultraviolet light (wavelength of 350 to 430 nm) in combination of the semiconductor light-emitting element and the phosphors has been developed.
Conventionally, green phosphors having various compositions have been developed. For example, Patent Literature 1 describes a phosphor corresponding to $(Ba,Sr)_2SiO_4$:Eu as a green phosphor used in an LED or the like. This Literature describes that at least one of an alkali metal element, an alkaline earth metal element, Zn, Y, Al, Sc, P, N, a rare earth element, and a halogen element is contained as a trace element and that the content of the trace element is usually from 1 ppm to 100 ppm, but does not describe Example in which the trace element is added.
Patent Literature 2 describes a silicate green light-emitting phosphor obtained by activating strontium barium silicate with europium, in which the content of magnesium is from 0.15 to 0.90 moles relative to 1 mole of the content of silicon.

Citation List

Patent Literature

Patent Literature 1: JP 2008-266410 A (claim 10, paragraphs 0052, 0053, and the like)
Patent Literature 2: JP 2013-136697 A (claim 1)

Summary of Invention

Technical Problem

The green phosphor described in Patent Literature 1 has an insufficient light-emitting characteristic, particularly has a low internal quantum efficiency and a low external quantum efficiency disadvantageously. The silicate green light-emitting phosphor described in Patent Literature 2 has a high stability of a light-emitting intensity with respect to heat, but further improvement in a light-emitting characteristic is expected.
An object of the present invention is to provide a phosphor having a better light-emitting characteristic, particularly a better external quantum efficiency than a conventional phosphor, and a light-emitting device using the same.

Solution to Problem

The present inventors made intensive studies in order to achieve the above object. As a result, the present inventors have found that a phosphor obtained by activating strontium barium silicate with europium can exhibit an excellent light-emitting characteristic due to addition of a predetermined group 3 element.
That is, the present invention relates to a phosphor represented by a composition of the following formula (1),

$$(Sr_a,Ba_b,Ca_c,Eu_x,M^1{}_d,M^2{}_e)SiO_f \cdot gMgO \cdots \qquad \text{formula (1)}$$

(here, $M^1$ represents at least one group 3 element selected from Lu and Sc, $M^2$ represents an alkali metal element selected from Li, Na, and K, and $0 < a \leq 2$, $0 < b \leq 2$, $0 \leq c \leq 2$, $0.0015 \leq d \leq 0.045$, $0 \leq e \leq 0.06$, $0 < x \leq 0.1$, $3.7 \leq f \leq 4.1$, and $0 \leq g \leq 1$ are satisfied).
In addition, the present invention relates to a light-emitting device including the phosphor and a light source for irradiating the phosphor with excitation light to cause the phosphor to emit light.

Advantageous Effects of Invention

The present invention can provide a phosphor having an excellent light-emitting characteristic, particularly an excellent external quantum efficiency, and a light-emitting device using the same.

Description of Embodiments

1. Phosphor

A phosphor of the present invention is represented by a composition of the following formula (1),

$$(Sr_a, Ba_b, Ca_c, Eu_x, M^1_d, M^2_e)SiO_f \cdot gMgO \cdots \qquad \text{formula (1)}$$

(here, $M^1$ represents at least one group 3 element selected from Lu and Sc, $M^2$ represents an alkali metal element selected from Li, Na, and K, and $0 < a \le 2$, $0 < b \le 2$, $0 \le c \le 2$, $0.0015 \le d \le 0.045$, $0 \le e \le 0.06$, $0 < x \le 0.1$, $3.7 \le f \le 4.1$, and $0 \le g \le 1$ are satisfied).

In other words, the phosphor of the present invention is a silicate green phosphor obtained by activating an alkaline earth metal silicate with europium, containing at least one group 3 element ($M^1$) selected from lutetium (Lu) and scandium (Sc) and magnesium (Mg) as an optional component.

In formula (1), $M^1$ is at least one group 3 element selected from Lu and Sc, and may contain only Lu and Sc or may contain two or more kinds thereof. Of these elements, Lu is more preferable due to a high internal quantum efficiency or a high external quantum efficiency.

A molar ratio of $M^1$ relative to 1 mole of Si, that is, the value of d is within a range of $0.0015 \le d \le 0.045$, preferably within a range of $0.002 \le d \le 0.04$, and more preferably within a range of $0.008 \le d \le 0.03$. Even when the value of d is less than 0.0015 or more than 0.045, the internal quantum efficiency or the external quantum efficiency is lowered, and a light-emitting characteristic is easily deteriorated. Note that the content of $M^1$ is preferably from 1000 to 25000 ppm, and more preferably from 4000 to 15000 ppm relative to the total amount of the phosphor based on a mass. Even when the content of $M^1$ is less than 1000 ppm or more than 25000 ppm, the internal quantum efficiency or the external quantum efficiency is lowered, and a light-emitting characteristic is easily deteriorated. The content of $M^1$ can be calculated from a mixing ratio of raw materials.

A molar ratio of strontium relative to 1 mole of Si, that is, the value of a is within a range of $0 < a \le 2$, preferably within a range of $0.1 \le a \le 1.9$, more preferably within a range of $1 \le a \le 1.5$, and particularly preferably within a range of $0.96 \le a \le 1.2$. As the value of a is closer to zero, a full width at half maximum of a light-emitting spectrum is easily narrower. When the value of a is 2 or more, a light-emitting intensity is easily lowered.

A molar ratio of barium relative to 1 mole of Si, that is, the value of b is within a range of $0 < b \le 2$, preferably within a range of $0.1 \le b \le 1.9$, more preferably within a range of $0.5 \le b \le 0.98$, and particularly preferably within a range of $0.6 \le b \le 0.96$. As the value of b is closer to zero, a light-emitting intensity is easily lowered. When the value of b is 1 or more, a full width at half maximum of a light-emitting spectrum is easily narrower.

In the present invention, calcium (Ca) can be contained as an optional component. A molar ratio of calcium relative to 1 mole of Si, that is, the value of c is within a range of $0 \le c \le 2$, and is usually c = 0 is satisfied.

Europium is an activating agent, and emits light as a light-emitting atom in a phosphor. A molar ratio of europium relative to 1 mole of Si, that is, the value of x is within a range $0 < x \le 0.1$, preferably within a range of $0.01 \le x \le 0.07$, and more preferably within a range of $0.03 \le x \le 0.04$. As the value of x is closer to zero, the number of the light-emitting atoms is less, and therefore a light-emitting intensity is easily lowered. When the value of x is 0.1 or more, the light-emitting atoms have a high concentration, and cancel light-emission to each other due to being close to each other, and therefore a light-emitting intensity is easily lowered.

a + b + c + x + d + e preferably satisfies $1.7 \le a + b + c + x + d + e \le 2.1$, more preferably satisfies $1.8 \le a + b + c + x + d + e \le 2.0$, and particularly preferably satisfies a + b + c + x + d + e = 1.9.

In the present invention, magnesium is an optional component. However, a case where the phosphor contains magnesium is preferable because the internal quantum efficiency or the external quantum efficiency of the phosphor is higher than a case where the phosphor contains no magnesium. A molar ratio of magnesium relative to 1 mole of Si, that is, the value of g is within a range of $0 \le g \le 1$, preferably within a range of $0.15 \le g \le 0.90$, and more preferably within a range of $0.20 \le g \le 0.80$. A case of c = 0 has a composition containing no magnesium. Note that a phosphor containing magnesium is a mixture of a silicate phosphor containing no Mg, such as a phosphor represented by "$(Sr_a, Ba_b, Ca_c, M^1_d, M^2_e)SiO_f{:}Eu_x$" or a phosphor represented by "$(Sr_{a-\alpha}, Ba_{b-\beta}, Ca_{c-\gamma}, M^1_d, Mg_{\alpha+\beta+\gamma})SiO_f{:}Eu_x$" ($0 \le \alpha + \beta + \gamma \le 0.2$)", and MgO or the like. For example, the phosphor containing magnesium can be obtained by firing raw materials in a manufacturing method described below such that a molar ratio of the raw materials is strontium element:barium element:calcium element :magnesium element:$M^1$ element:$M^2$ element:silicon element:europium element = a:b:c:g:d:e:1:x.

In the present invention, an alkali metal element ($M^2$) can be further contained as an optional component. The alkali metal element is preferably contained in the phosphor because the alkali metal element sensitizes $M^1$ as a group 3 element in the phosphor to improve an internal quantum efficiency or an external quantum efficiency. The alkali metal element is preferably at least one selected from lithium (Li), sodium (Na), and potassium (K). The molar content of the alkali metal element contained in the phosphor is preferably the same as that of $M^1$ (1:1 in a molar ratio, that is, e = d) when a molar ratio of the alkali metal element relative to 1 mole of Si is e. When an alkali metal (element $M^2$) is contained, the content thereof is preferably within a range of $0.001 \leq e \leq 0.06$, more preferably within a range of $0.0015 \leq e \leq 0.05$, and particularly preferably within a range of $0.0025 \leq e \leq 0.03$. Note that a case of e = 0 has a composition containing no alkali metal element.

Note that when the phosphor of the present invention contains no alkali metal element ($M^2$), the phosphor can be represented by the following formula (2).

$$(Sr_a, Ba_b, Ca_c, Eu_x, M^1_d)SiO_f \cdot gMgO \cdots \qquad \text{formula (2)}$$

(here, $M^1$ represents at least one group 3 element selected from Lu and Sc, and $0 < a \leq 2$, $0 < b \leq 2$, $0 < c \leq 2$, $0.0015 \leq d \leq 0.045$, $0 < x \leq 0.1$, $3.7 \leq f \leq 4.1$, and $0 \leq g \leq 1$ are satisfied).

In formula (1), $3.7 \leq f \leq 4.1$ is satisfied, $3.8 \leq f \leq 4.0$ is preferably satisfied, and f = 3.9 is more preferably satisfied. When f is less than 3.7 or more than 4.1, a light-emitting efficiency is easily lowered.

The phosphor of the present invention emits green light having a peak wavelength within a range of 510 to 530 nm when being excited with light having a wavelength of 400 nm. Furthermore, the phosphor of the present invention preferably emits blue light having a peak wavelength within a range of 435 to 450 nm together with the green light. The light-emitting intensity of the blue light is preferably within a range of 0.0015 to 0.020, particularly preferably within a range of 0.005 to 0.010 when the light-emitting intensity of the green light is assumed to be 1.

As described above, the phosphor of the present invention contains at least one group 3 element selected from Lu and Sc, has the composition of formula (1), and therefore has a better light-emitting characteristic indicated particularly by an internal quantum efficiency or an external quantum efficiency than a conventional phosphor. The internal quantum efficiency means the number of generated photons relative to the number of absorbed excitation photons. On the other hand, the external quantum efficiency means the number of externally generated photons relative to the number of irradiated photons, and can be calculated by a formula "internal quantum efficiency x absorption ratio". The external quantum efficiency means the light-emitting amount relative to the number of photons irradiated by an excitation source. Therefore, particularly in a light-emitting device such as a white LED, the external quantum efficiency is a more important parameter than the internal quantum efficiency. The phosphor of the present invention has a better external quantum efficiency than a conventional phosphor when being excited with light of 390 to 420 nm. Specifically, when the phosphor of the present invention is excited with excitation light having a wavelength of 400 nm, the phosphor of the present invention can have an external quantum efficiency of 65.8% or more, preferably of 67% or more, and more preferably of 68% or more. Here, the external quantum efficiency can be calculated by a method described in Examples described below.

2. Method for manufacturing phosphor

The phosphor of the present invention can be manufactured by a method for mixing a strontium compound powder, a barium compound powder, a calcium compound powder, a silicon compound powder, a $M^1$-containing compound powder, and a europium compound powder, optionally mixing a magnesium compound powder and/or a $M^2$-containing compound powder, and firing the resulting powdery mixture.

Each of raw material powders of the strontium compound powder, the barium compound powder, the calcium compound powder, the silicon compound powder, the $M^1$-containing compound powder, the europium compound powder, the $M^2$-containing compound powder, and the magnesium compound powder may be an oxide powder or a powder of a compound to generate an oxide by heating, such as a hydroxide, a halide, a carbonate (including a basic carbonate), a nitrate, or an oxalate.

Specific examples of the strontium compound powder are not particularly limited. However, for example, at least one selected from the group consisting of strontium carbonate ($SrCO_3$), strontium hydroxide ($Sr(OH)_2$), strontium fluoride ($SrF_2$), strontium bromide ($SrBr_2$), strontium chloride ($SrCl_2$), and strontium iodide ($SrI_2$) can be used.

Specific examples of the barium compound powder are not particularly limited. However, for example, at least one selected from the group consisting of barium carbonate ($BaCO_3$), barium hydroxide ($Ba(OH)_2$), barium fluoride ($BaF_2$), barium bromide ($BaBr_2$), barium chloride ($BaCl_2$), and barium iodide ($BaI_2$) can be used.

Specific examples of the calcium compound powder are not particularly limited. However, for example, at least one selected from the group consisting of calcium carbonate ($CaCO_3$), calcium hydroxide ($Ca(OH)_2$), calcium fluoride

($CaF_2$), calcium bromide ($CaBr_2$), calcium chloride ($CaCl_2$), and calcium iodide ($CaI_2$) can be used.

Specific examples of the silicon compound powder are not particularly limited. However, for example, at least one selected from the group consisting of silicon dioxide ($SiO_2$), orthosilicic acid ($H_4SiO_4$), metasilicic acid ($H_2SiO_3$), and metadisilicic acid ($H_2Si_2O_5$ can be used.

Specific examples of the magnesium compound powder are not particularly limited. However, for example, at least one selected from the group consisting of magnesium oxide (MgO), magnesium hydroxide ($Mg(OH)_2$), and magnesium carbonate ($MgCO_3$) can be used.

The $M^1$-containing compound powder can be selected from a lutetium compound powder, a scandium compound powder, and a mixed powder of two or more kinds thereof. Specific examples of the lutetium compound powder are not particularly limited. However, for example, lutetium (III) oxide ($Lu_2O_3$) can be used. Specific examples of the scandium compound powder are not particularly limited. However, for example, scandium (III) oxide ($Sc_2O_3$) can be used.

The $M^2$-containing compound powder can be selected from a lithium compound powder, a sodium compound powder, a potassium compound powder, and a mixed powder of two or more kinds thereof. Specific examples of the lithium compound powder are not particularly limited. However, for example, lithium carbonate ($Li_2CO_3$) can be used.

Specific examples of the europium compound powder are not particularly limited. However, for example, at least one selected from the group consisting of europium (III) oxide ($Eu_2O_3$), europium (II) oxide (EuO), and europium (III) hydroxide ($Eu(OH)_3$) can be used.

These raw material powders may be used singly or in combination of two or more kinds thereof. Each of the raw material powders preferably has a purity of 99% by mass or more.

A mixing ratio of the raw material powders is almost directly a composition ratio of formula (1). Therefore, the mixing ratio is adjusted so as to obtain a desired composition ratio. That is, a strontium compound powder is mixed such that the molar number of a strontium element is a relative to 1 mole of the content of silicon in the raw material powders. The other compound powders are similar.

A flux may be added to a mixture of the raw material powders. The flux is preferably a halide, and is particularly preferably a chloride. A chloride powder is preferably used for a part of the raw material powders as the flux. A strontium chloride powder is particularly preferably used. The addition amount of the flux is such an amount that the halogen amount is preferably within a range of 0.0001 to 0.5 moles, particularly preferably within a range of 0.01 to 0.5 moles when the silicon content in the powdery mixture is 1 mole.

Both a dry mixing method and a wet mixing method can be employed as a method for mixing the raw material powders. When the raw material powders are mixed by the wet mixing method, a rotating ball mill, a vibrating ball mill, a planetary mill, a paint shaker, a rocking mill, a rocking mixer, a bead mill, a stirrer, and the like can be used. Water or a lower alcohol such as ethanol or isopropyl alcohol can be used as a solvent.

The powdery mixture is preferably fired under a reducing gas atmosphere. As the reducing gas, a mixed gas of 0.5 to 5.0% by volume hydrogen and a 99.5 to 95.0% by volume inert gas can be used. Examples of the inert gas include argon and/or nitrogen. A firing temperature is generally within a range of 900 to 1300°C. Firing time is generally within a range of 0.5 to 100 hours, and preferably within a range of 0.5 to 10 hours.

When the powder of a compound to generate an oxide by heating is used as the raw material powder, a powdery mixture is preferably calcined under an air atmosphere at a temperature of 600 to 850°C for 0.5 to 100 hours before being fired under a reducing gas atmosphere. Calcination time is particularly preferably within a range of 0.5 to 10 hours. A phosphor obtained by firing may be subjected to a classification treatment, an acid washing treatment with a mineral acid such as hydrochloric acid or nitric acid, or a baking treatment, as necessary.

3. Light-emitting device

The phosphor of the present invention can be used for various light-emitting devices. A light-emitting device of the present invention includes at least the phosphor represented by the above formula (1) and a light source for irradiating the phosphor with excitation light to cause the phosphor to emit light. Specific examples of the light-emitting device include a white light-emitting diode (LED), a fluorescent lamp, a vacuum fluorescent display (VFD), a cathode ray tube (CRT), a plasma display panel (PDP), and a field emission display (FED). Among these devices, the white LED is a light-emitting device including the phosphor of the present invention (green phosphor), a red phosphor, a blue phosphor, and a semiconductor light-emitting element to emit ultraviolet light, for example, having a wavelength of 350 to 430 nm, and exciting these phosphors with ultraviolet light emitted by the light-emitting element to obtain white by mixing green, red, and blue.

Examples of the blue light-emitting phosphor include $(Ba,Sr,Ca)_3MgSi_2O_8$:Eu, $(Ba,Sr,Ca)MgAl_{10}O_{17}$:Eu, and $(Ba,Sr,Mg, Ca)_{10}(PO_4)_6(Cl,F)_2$:Eu. Examples of the red light-emitting phosphor include $(Ba,Sr,Ca)_3MgSi_2O_8$:Eu,Mn, $Y_2O_2S$:Eu, $La_2O_3S$:Eu, $(Ca,Sr,Ba)_2Si_5N_8$:Eu, $CaAlSiN_3$:Eu, $Eu_2W_2O_9$, $(Ca,Sr,Ba)_2Si_5N_8$:Eu,Mn, $CaTiO_3$:Pr,Bi, and $(La,Eu)_2W_3O_{12}$. Examples of the semiconductor light-emitting element include an AlGaN-based semiconductor light-emitting element. Patent Literature 2 can be referred to for details of the light-emitting device.

Examples

Hereinafter, the present invention will be described specifically based on Examples, but an object of the present invention is not limited thereby.

1. Method for evaluating characteristic of phosphor

A method for evaluating various characteristics of a phosphor is as follows.

<Absorption ratio, internal quantum efficiency, and external quantum efficiency>

Measurement was performed by the following procedure using FP-8500 manufactured by JASCO Corporation.

1) A standard white plate was attached to an inner bottom of an integrating sphere. This standard white plate was irradiated with ultraviolet light having a peak wavelength of 400 nm perpendicularly to a surface thereof. A spectrum of light scattered by a wall of the integrating sphere was measured, and a peak area (L1> of light having a wavelength of 380 to 410 nm was measured.
2) A silicate phosphor sample was put in a sample holder, and the sample holder was attached to the inner bottom of the integrating sphere. The silicate phosphor sample in the sample holder was irradiated with ultraviolet light having a peak wavelength of 400 nm perpendicularly to a surface thereof. A spectrum of light scattered by a wall of the integrating sphere was measured, and a peak area (L2) of light having a wavelength of 380 to 410 nm and a peak area (E) of light having a wavelength of 410 to 700 nm were measured. An absorption ratio of the silicate phosphor sample, an internal quantum efficiency thereof, and an external quantum efficiency thereof were calculated based on the following formula.

```
absorption ratio (%) = 100 × (L1 - L2)/L1
```

```
internal quantum efficiency (%) (of silicate phosphor
sample) =100 × E/(L1 - L2)
```

```
external quantum efficiency (%) (of silicate phosphor
sample) =100 × E/L1
```

2. Experimental Example 1: $M^1$ = Lu

(Example 1: $Sr_{1.013}Ba_{0.85}Eu_{0.035}Lu_{0.002}SiO_{3.901} \cdot 0.3MgO$)

A strontium carbonate powder (purity: 99.8% by mass, average particle diameter: 2.73 $\mu$m), a barium carbonate powder (purity: 99.8% by mass, average particle diameter: 1.26 $\mu$m), a dieuropium trioxide powder (purity: 99.9% by mass, average particle diameter: 2.71 $\mu$m), a silicon dioxide powder (purity: 99. 9% by mass, average particle diameter: 3.87 $\mu$m), a magnesium oxide powder (manufactured by a gas phase method, purity: 99.98% by mass, BET specific surface area: 8 $m^2$/g), a strontium fluoride powder (purity: 99.9% by mass), a strontium bromide powder (purity: 99.9% by mass), lutetium (III) oxide (purity: 99.9% by mass) were weighed such that a molar ratio of $SrCO_3:BaCO_3:Eu_2O_3:SiO_2:MgO:SrF_2:SrBr_2:Lu_2O_3$ was 0.993:0.85:0.0175:1:0.3:0.01:0.01:0.001 (Table 1). Note that an average particle diameter of each of the raw material powders was measured by a laser diffraction scattering method.
Each of the weighed raw material powders was put in a ball mill together with pure water, and was mixed in a wet manner for 24 hours to obtain a slurry of a powdery mixture. The resulting slurry was spray-dried with a spray dryer to obtain a powdery mixture having an average particle diameter of 40 $\mu$m. The resulting powdery mixture was put in an alumina crucible, was fired at a temperature of 800°C in an air atmosphere for 3 hours, and then was cooled to room temperature. Thereafter, the resulting product was fired in a mixed gas atmosphere of 2% by volume of hydrogen-98% by volume of argon at a temperature of 1200°C for 6 hours to obtain a phosphor $(Sr_{1.013}Ba_{0.85}Eu_{0.035}Lu_{0.002}SiO_{3.9} \cdot 0.3MgO)$.

An absorption ratio of the resulting phosphor, an internal quantum efficiency thereof, and an external quantum efficiency thereof were measured and calculated. As a result, the absorption ratio was 81.2%, the internal quantum efficiency was 81.0%, and the external quantum efficiency was 65.8%. Table 2 indicates these results. Note that the oxygen number in each composition is a theoretical value calculated by assuming that each of Sr, Ba, Eu, Si, and Mg has the valence number of two, and $M^1$ has the valence number of three.

(Example 2: $Sr_{1.011}Ba_{0.85}Eu_{0.035}Lu_{0.004}SiO_{3.902} \cdot 0.3MgO$)

A phosphor $(Sr_{1.011}Ba_{0.85}Eu_{0.035}Lu_{0.004}SiO_{3.9} \cdot 0.3MgO)$ was obtained in a similar manner to Example 1 except that the raw material powders in Example 1 were mixed so as to obtain a mixing ratio in Table 1. An absorption ratio of the resulting phosphor, an internal quantum efficiency thereof, and an external quantum efficiency thereof were measured and calculated. Table 2 indicates the results.

(Example 3: $Sr_{1.009}Ba_{0.85}Eu_{0.035}Lu_{0.006}SiO_{3.903} \cdot 0.3MgO$)

A phosphor $(Sr_{1.009}Ba_{0.85}Eu_{0.035}Lu_{0.002}SiO_{3.9} \cdot 0.3MgO)$ was obtained in a similar manner to Example 1 except that the raw material powders in Example 1 were mixed so as to obtain a mixing ratio in Table 1. An absorption ratio of the resulting phosphor, an internal quantum efficiency thereof, and an external quantum efficiency thereof were measured and calculated. Table 2 indicates the results.

(Example 4: $Sr_{1.007}Ba_{0.85}Eu_{0.035}Lu_{0.008}SiO_{3.904} \cdot 0.3MgO$)

A phosphor $(Sr_{1.007}Ba_{0.85}Eu_{0.035}Lu_{0.008}SiO_{3.9} \cdot 0.3MgO)$ was obtained in a similar manner to Example 1 except that the raw material powders in Example 1 were mixed so as to obtain a mixing ratio in Table 1. An absorption ratio of the resulting phosphor, an internal quantum efficiency thereof, and an external quantum efficiency thereof were measured and calculated. Table 2 indicates the results.

(Example 5: $Sr_{1.005}Ba_{0.85}Eu_{0.035}Lu_{0.01}SiO_{3.905} \cdot 0.3MgO$)

A phosphor $(Sr_{1.005}Ba_{0.85}Eu_{0.035}Lu_{0.01}SiO_{3.9} \cdot 0.3MgO)$ was obtained in a similar manner to Example 1 except that the raw material powders in Example 1 were mixed so as to obtain a mixing ratio in Table 1. An absorption ratio of the resulting phosphor, an internal quantum efficiency thereof, and an external quantum efficiency thereof were measured and calculated. Table 2 indicates the results.

(Example 6: $Sr_{1.003}Ba_{0.85}Eu_{0.035}Lu_{0.12}SiO_{3.906} \cdot 0.3MgO$)

A phosphor $(Sr_{1.003}Ba_{0.85}Eu_{0.035}Lu_{0.012}SiO_{3.9} \cdot 0.3MgO)$ was obtained in a similar manner to Example 1 except that the raw material powders in Example 1 were mixed so as to obtain a mixing ratio in Table 1. An absorption ratio of the resulting phosphor, an internal quantum efficiency thereof, and an external quantum efficiency thereof were measured and calculated. Table 2 indicates the results.

(Example 7: $Sr_{0.995}Ba_{0.85}Eu_{0.035}Lu_{0.02}SiO_{3.91} \cdot 0.3MgO$)

A phosphor $(Sr_{0.995}Ba_{0.85}Eu_{0.035}Lu_{0.02}SiO_{3.9} \cdot 0.3MgO)$ was obtained in a similar manner to Example 1 except that the raw material powders in Example 1 were mixed so as to obtain a mixing ratio in Table 1. An absorption ratio of the resulting phosphor, an internal quantum efficiency thereof, and an external quantum efficiency thereof were measured and calculated. Table 2 indicates the results.

(Example 8: $Sr_{0.985}Ba_{0.85}Eu_{0.035}Lu_{0.03}SiO_{3.915} \cdot 0.3MgO$)

A phosphor $Sr_{0.985}Ba_{0.85}Eu_{0.035}Lu_{0.03}SiO_{3.9} \cdot 0.3MgO)$ was obtained in a similar manner to Example 1 except that the raw material powders in Example 1 were mixed so as to obtain a mixing ratio in Table 1. An absorption ratio of the resulting phosphor, an internal quantum efficiency thereof, and an external quantum efficiency thereof were measured and calculated. Table 2 indicates the results.

(Example 9: $Sr_{0.975}Ba_{0.85}Eu_{0.035}Lu_{0.04}SiO_{3.92} \cdot 0.3MgO$)

A phosphor ($Sr_{0.975}Ba_{0.85}Eu_{0.035}Lu_{0.04}SiO_{3.9} \cdot 0.3MgO$) was obtained in a similar manner to Example 1 except that the raw material powders in Example 1 were mixed so as to obtain a mixing ratio in Table 1. An absorption ratio of the resulting phosphor, an internal quantum efficiency thereof, and an external quantum efficiency thereof were measured and calculated. Table 2 indicates the results.

(Comparative Example 1: $Sr_{1015}Ba_{0.85}Eu_{0.035}SiO_{3.9} \cdot 0.3MgO$)

A phosphor ($Sr_{1015}Ba_{0.85}Eu_{0.035}SiO_{3.9} \cdot 0.3MgO$) was obtained in a similar manner to Example 1 except that the raw material powders were mixed so as to obtain a mixing ratio in Table 1 without addition of lutetium (III) oxide in Example 1. An absorption ratio of the resulting phosphor, an internal quantum efficiency thereof, and an external quantum efficiency thereof were measured and calculated. Table 2 indicates the results.

(Comparative Example 2: $Sr_{1.014}Ba_{0.85}Eu_{0.035}Lu_{0.001}SiO_{3.9005} \cdot 0.3MgO$)

A phosphor ($Sr_{1.014}Ba_{0.85}Eu_{0.035}Lu_{0.001}SiO_{3.9} \cdot 0.3MgO$) was obtained in a similar manner to Example 1 except that the raw material powders in Example 1 were mixed so as to obtain a mixing ratio in Table 1. An absorption ratio of the resulting phosphor, an internal quantum efficiency thereof, and an external quantum efficiency thereof were measured and calculated. Table 2 indicates the results.

(Comparative Example 3: $Sr_{0.965}Ba_{0.85}Eu_{0.035}Lu_{0.05}SiO_{3.925} \cdot 0.3MgO$)

A phosphor ($Sr_{0.965}Ba_{0.85}Eu_{0.035}Lu_{0.05}SiO_{3.9} \cdot 0.3MgO$) was obtained in a similar manner to Example 1 except that the raw material powders in Example 1 were mixed so as to obtain a mixing ratio in Table 1. An absorption ratio of the resulting phosphor, an internal quantum efficiency thereof, and an external quantum efficiency thereof were measured and calculated. Table 2 indicates the results.

The above results indicate the following. That is, when Comparative Example 1 containing no lutetium or Comparative Example 2 in which the content of lutetium is 0.001 (molar ratio relative to 1 mole of silicon, hereinafter, the same) is compared to Examples 1 to 9 in which the content of lutetium is 0.002 or more, both the internal quantum efficiencies and the external quantum efficiencies in Examples 1 to 9 are better than those in Comparative Examples 1 and 2. Therefore, it is found that the content of lutetium is preferably 0.0015 or more, and particularly preferably 0.002 or more. On the other hand, even when Comparative Example 3 in which the content of lutetium is 0.05 is compared to Examples 1 to 9, both the internal quantum efficiencies and the external quantum efficiencies in Examples 1 to 9 are better than those in Comparative Example 3. Therefore, it is found that the content of lutetium is preferably 0.045 or less, and particularly preferably 0.04 or less.

3. Experimental Example 2: $M^1$ = Sc

(Example 10: $Sr_{1.005}Ba_{0.85}Eu_{0.035}SC_{0.01}SiO_{3 \cdot 905} \cdot 0.3MgO$)

A phosphor ($Sr_{1.005}Ba_{0.85}Eu_{0.035}Sc_{0.01}SiO_{3.9} \cdot 0.3MgO$) was obtained in a similar manner to Example 5 except that the raw material powders were mixed so as to obtain a mixing ratio in Table 1 using scandium (III) oxide in place of lutetium (III) oxide in Example 5. An absorption ratio of the resulting phosphor, an internal quantum efficiency thereof, and an external quantum efficiency thereof were measured and calculated. Table 2 indicates the results.

The above results indicate the following. That is, when Comparative Example 1 containing no scandium is compared to Example 10 in which the content of scandium is 0.01, the external quantum efficiencies in Examples 1 to 9 are better than that in Comparative Example 1. Therefore, it has been found that even in case where scandium is contained in place of lutetium, a phosphor has an excellent external quantum efficiency. Note that the result in Example 5 containing lutetium the molar ratio of which is the same as that of scandium in Example 10 indicates that lutetium exhibits a better internal quantum efficiency and a better external quantum efficiency than scandium.

4. Experimental Example 3: $M^1$ = various metal elements

(Comparative Examples 4 to 11)

A phosphor was obtained in a similar manner to Example 5 except that lutetium (III) oxide in Example 5 was changed to oxides containing various metal elements indicated in Comparative Examples 4 to 11 in Table 1 and the raw material powders were mixed so as to obtain a mixing ratio in Table 1. An absorption ratio of the resulting phosphor, an internal quantum efficiency thereof, and an external quantum efficiency thereof were measured and calculated. Table 2 indicates the results.

The above results indicate the following. That is, when Example 5 containing lutetium or Example 10 containing scandium is compared to Comparative Examples 4 to 11 containing other metal elements, both the internal quantum efficiencies and the external quantum efficiencies in Examples 5 and 10 are better than those in Comparative Examples 4 to 11. Therefore, it is found that a phosphor containing lutetium or scandium has a better internal quantum efficiency and a better external quantum efficiency than phosphors containing other metal elements indicated in Comparative Examples 4 to 11 in Table 1.

[Table 1]

| | mixing ratio of raw materials | | | | | | | | | | | | | | | | |
|---|---|---|---|---|---|---|---|---|---|---|---|---|---|---|---|---|---|
| | $SrCO_3$ | $BaCO_3$ | $Eu_2O_3$ | $SiO_2$ | MgO | $SrF_2$ | $SrBr_2$ | $Lu_2O_3$ | $Sc_2O_3$ | $Nd_2O_3$ | $Sm_2O_3$ | $Dy_2O_3$ | $Ho_2O_3$ | $Er_2O_3$ | $Tm_2O_3$ | $Yb_2O_3$ | $Pr_6O_{11}$ |
| Comparative Example 1 | 0.995 | 0.85 | 0.0175 | 1 | 0.3 | 0.01 | 0.01 | - | - | - | - | - | - | - | - | - | - |
| Comparative Example 2 | 0.991 | 0.85 | 0.0175 | 1 | 0.3 | 0.01 | 0.01 | 0.0005 | - | - | - | - | - | - | - | - | - |
| Example 1 | 0.993 | 0.85 | 0.0175 | 1 | 0.3 | 0.01 | 0.01 | 0.001 | - | - | - | - | - | - | - | - | - |
| Example 2 | 0.991 | 0.85 | 0.0175 | 1 | 0.3 | 0.01 | 0.01 | 0.002 | - | - | - | - | - | - | - | - | - |
| Example 3 | 0.989 | 0.85 | 0.0175 | 1 | 0.3 | 0.01 | 0.01 | 0.003 | - | - | - | - | - | - | - | - | - |
| Example 4 | 0.987 | 0.85 | 0.0175 | 1 | 0.3 | 0.01 | 0.01 | 0.004 | - | - | - | - | - | - | - | - | - |
| Example 5 | 0.985 | 0.85 | 0.0175 | 1 | 0.3 | 0.01 | 0.01 | 0.005 | - | - | - | - | - | - | - | - | - |
| Example 6 | 0.983 | 0.85 | 0.0175 | 1 | 0.3 | 0.01 | 0.01 | 0.006 | - | - | - | - | - | - | - | - | - |
| Example 7 | 0.975 | 0.85 | 0.0175 | 1 | 0.3 | 0.01 | 0.01 | 0.01 | - | - | - | - | - | - | - | - | - |
| Example 8 | 0.965 | 0.85 | 0.0175 | 1 | 0.3 | 0.01 | 0.01 | 0.015 | - | - | - | - | - | - | - | - | - |
| Example 9 | 0.955 | 0.85 | 0.0175 | 1 | 0.3 | 0.01 | 0.01 | 0.02 | - | - | - | - | - | - | - | - | - |
| Comparative Example 3 | 0.945 | 0.85 | 0.0175 | 1 | 0.3 | 0.01 | 0.01 | - | - | - | - | - | - | - | - | - | - |
| Example 10 | 0.985 | 0.85 | 0.0175 | 1 | 0.3 | 0.01 | 0.01 | - | 0.005 | - | - | - | - | - | - | - | - |
| Comparative Example 4 | 0.985 | 0.85 | 0.0175 | 1 | 0.3 | 0.01 | 0.01 | - | - | 0.005 | - | - | - | - | - | - | - |
| Comparative Example 5 | 0.985 | 0.85 | 0.0175 | 1 | 0.3 | 0.01 | 0.01 | - | - | - | 0.005 | - | - | - | - | - | - |
| Comparative Example 6 | 0.985 | 0.85 | 0.0175 | 1 | 0.3 | 0.01 | 0.01 | - | - | - | - | 0.005 | - | - | - | - | - |
| Comparative Example 7 | 0.985 | 0.85 | 0.0175 | 1 | 0.3 | 0.01 | 0.01 | - | - | - | - | - | 0.005 | - | - | - | - |
| Comparative Example 8 | 0.985 | 0.85 | 0.0175 | 1 | 0.3 | 0.01 | 0.01 | - | - | - | - | - | - | 0.005 | - | - | - |

| | mixing ratio of raw materials | | | | | | | | | | | | | | | | |
|---|---|---|---|---|---|---|---|---|---|---|---|---|---|---|---|---|---|
| | $SrCO_3$ | $BaCO_3$ | $Eu_2O_3$ | $SiO_2$ | MgO | $SrF_2$ | $SrBr_2$ | $Lu_2O_3$ | $Sc_2O_3$ | $Nd_2O_3$ | $Sm_2O_3$ | $Dy_2O_3$ | $Ho_2O_3$ | $Er_2O_3$ | $Tm_2O_3$ | $Yb_2O_3$ | $Pr_6O_{11}$ |
| Comparative Example 9 | 0.985 | 0.85 | 0.0175 | 1 | 0.3 | 0.01 | 0.01 | - | - | - | - | - | - | - | 0.005 | - | - |
| Comparative Example 10 | 0.985 | 0.85 | 0.0175 | 1 | 0.3 | 001 | 0.01 | - | - | - | - | - | - | - | - | 0.005 | - |
| Comparative Example 11 | 0.985 | 0.85 | 0.0175 | 1 | 0.3 | 0.01 | 0.01 | - | - | - | - | - | - | - | - | - | 0.0017 |

[Table 2]

| | composition | absorption ratio | internal | external |
|---|---|---|---|---|
| Comparative Example 1 | $Sr_{1.015}Ba_{0.85}Eu_{0.035}SiO_{3.9} \cdot 0.3MgO$ | 81.5 | 80.5 | 65.6 |
| Comparative Example 2 | $Sr_{1.014}Ba_{0.85}Eu_{0.035}Lu_{0.001}SiO_{3.9005} \cdot 0.3MgO$ | 81.0 | 80.4 | 65.1 |
| Example 1 | $Sr_{1.013}Ba_{0.85}Eu_{0.035}Lu_{0.002}SiO_{3.901} \cdot 0.3MgO$ | 81.2 | 81.0 | 65.8 |
| Example 2 | $Sr_{1.011}Ba_{0.85}Eu_{0.035}Lu_{0.004}SiO_{3.902} \cdot 0.3MgO$ | 81.7 | 81.2 | 66.3 |
| Example 3 | $Sr_{1.009}Ba_{0.85}Eu_{0.035}Lu_{0.006}SiO_{3.903} \cdot 0.3MgO$ | 82.8 | 80.7 | 66.8 |
| Example 4 | $Sr_{1.007}Ba_{0.85}Eu_{0.035}Lu_{0.008}SiO_{3.904} \cdot 0.3MgO$ | 83.0 | 81.0 | 67.3 |
| Example 5 | $Sr_{1.005}Ba_{0.85}Eu_{0.035}Lu_{0.01}SiO_{3.905} \cdot 0.3MgO$ | 82.3 | 81.7 | 67.2 |
| Example 6 | $Sr_{1.003}Ba_{0.85}Eu_{0.035}Lu_{0.012}SiO_{3.905} \cdot 0.3MgO$ | 82.4 | 82.1 | 67.6 |
| Example 7 | $Sr_{0.995}Ba_{0.85}Eu_{0.035}Lu_{0.02}SiO_{3.91} \cdot 0.3MgO$ | 82.7 | 82.7 | 68.5 |
| Example 8 | $Sr_{0.985}Ba_{0.85}Eu_{0.035}Lu_{0.03}SiO_{3.915} \cdot 0.3MgO$ | 81.4 | 83.5 | 67.9 |
| Example 9 | $Sr_{0.975}Ba_{0.85}Eu_{0.035}Lu_{0.04}SiO_{3.92} \cdot 0.3MgO$ | 81.2 | 81.7 | 66.3 |
| Comparative Example 3 | $Sr_{0.965}Ba_{0.85}Eu_{0.035}Lu_{0.05}SiO_{3.925} \cdot 0.3MgO$ | 81.0 | 78.3 | 63.4 |
| Example 10 | $Sr_{1.005}Ba_{0.85}Eu_{0.035}Sc_{0.01}SiO_{3.905} \cdot 0.3MgO$ | 83.1 | 79.8 | 66.3 |
| Comparative Example 4 | $Sr_{1.005}Ba_{0.85}Eu_{0.035}Nd_{0.01}SiO_{3.905} \cdot 0.3MgO$ | 82.0 | 38.0 | 31.1 |
| Comparative Example 5 | $Sr_{1.005}Ba_{0.85}Eu_{0.035}Sm_{0.01}SiO_{3.905} \cdot 0.3MgO$ | 80.3 | 24.0 | 19.3 |
| Comparative Example 6 | $Sr_{1.005}Ba_{0.85}Eu_{0.035}Dy_{0.01}SiO_{3.905} \cdot 0.3MgO$ | 83.1 | 78.3 | 65.0 |
| Comparative Example 7 | $Sr_{1.005}Ba_{0.85}Eu_{0.035}Ho_{0.01}SiO_{3.905} \cdot 0.3MgO$ | 81.1 | 72.3 | 58.6 |
| Comparative Example 8 | $Sr_{1.005}Ba_{0.85}Eu_{0.035}Er_{0.01}SiO_{3.905} \cdot 0.3MgO$ | 83.0 | 69.2 | 57.5 |
| Comparative Example 9 | $Sr_{1.005}Ba_{0.85}Eu_{0.035}Tm_{0.01}SiO_{3.905} \cdot 0.3MgO$ | 83.0 | 76.4 | 63.4 |
| Comparative Example 10 | $Sr_{1.005}Ba_{0.85}Eu_{0.035}Yb_{0.01}SiO_{3.905} \cdot 0.3MgO$ | 82.6 | 70.5 | 58.3 |
| Comparative Example 11 | $Sr_{1.005}Ba_{0.85}Eu_{0.035}Pr_{0.01}SiO_{3.905} \cdot 0.3MgO$ | 84.3 | 62.8 | 52.9 |

5. Experimental Example 4: addition of Li

(Example 11: $Sr_{1.011}Ba_{0.85}Eu_{0.035}Lu_{0.004}SiO_{3.902} \cdot 0.3MgO$)

A phosphor ($Sr_{1.005}Ba_{0.85}Eu_{0.025}Lu_{0.01}Li_{0.01}SiO_{3.9} \cdot 0.3MgO$) was obtained in a similar manner to Example 1 except that the raw material powders in Example 1 were mixed so as to obtain a mixing ratio in Table 3 using a lithium carbonate powder (purity: 99% by mass) as a lithium source. An absorption ratio of the resulting phosphor, an internal quantum efficiency thereof, and an external quantum efficiency thereof were measured and calculated. Table 4 indicates the results.

(Comparative Examples 12 to 16)

A phosphor was obtained in a similar manner to Example 11 except that lutetium (III) oxide in Example 11 was changed to oxides containing various metal elements indicated in Comparative Examples 12 to 16 in Table 3 and the raw material powders were mixed so as to obtain a mixing ratio in Table 3. An absorption ratio of the resulting phosphor, an internal quantum efficiency thereof, and an external quantum efficiency thereof were measured and calculated. Table 4 indicates the results.

[Table 3]

| | mixing ratio of raw materials | | | | | | | | | | | | |
|---|---|---|---|---|---|---|---|---|---|---|---|---|---|
| | $SrCO_3$ | $BaCO_3$ | $Eu_2O_3$ | $SiO_2$ | MgO | $SrF_2$ | $SrBr_2$ | $Lu_2O_3$ | $Ce_2O_3$ | $La_2O_3$ | $W_2O_3$ | $Gd_2O_3$ | $Li_2CO_3$ |
| Example 11 | 0.985 | 0.85 | 0.0125 | 1 | 0.3 | 0.01 | 0.01 | 0.005 | | | | | 0.005 |
| Comparative Example 12 | 1.005 | 0.85 | 0.0125 | 1 | 0.3 | 0.01 | 0.01 | | | | | | 0.005 |
| Comparative Example 13 | 0.985 | 0.85 | 0.0125 | 1 | 0.3 | 0.01 | 0.01 | | 0.005 | | | | 0.005 |
| Comparative Example 14 | 0.985 | 0.85 | 0.0125 | 1 | 0.3 | 0.01 | 0.01 | | | 0.005 | | | 0.005 |
| Comparative Example 15 | 0.985 | 0.85 | 0.0125 | 1 | 0.3 | 0.01 | 0.01 | | | | 0.005 | | 0.005 |
| Comparative Example 16 | 0.985 | 0.85 | 0.0125 | 1 | 0.3 | 0.01 | 0.01 | | | | | 0.005 | 0.005 |

[Table 4]

| | composition | absorption ratio | internal | external |
|---|---|---|---|---|
| Example 11 | $Sr_{1.005}Ba_{0.85}Eu_{0.025}Lu_{0.01}Li_{0.01}SiO_{3.9}\cdot0.3MgO$ | 82.3 | 82.6 | 68.0 |
| Comparative Example 12 | $Sr_{1.025}Ba_{0.85}Eu_{0.025}Lu_{0.025}SiO_{3.9}\cdot0.3MgO$ | 81.4 | 80.4 | 66.4 |
| Comparative Example 13 | $Sr_{1.005}Ba_{0.85}Eu_{0.025}Ce_{0.01}Li_{0.01}SiO_{3.9}\cdot0.3MgO$ | 83.2 | 76.6 | 62.8 |
| Comparative Example 14 | $Sr_{1.005}Ba_{0.85}Eu_{0.025}La_{0.01}Li_{0.01}SiO_{3.9}\cdot0.3MgO$ | 83.1 | 77.4 | 64.3 |
| Comparative Example 16 | $Sr_{1.005}Ba_{0.85}Eu_{0.025}W_{0.01}Li_{0.01}SiO_{3.9}\cdot0.3MgO$ | 82.0 | 62.8 | 43.3 |
| Comparative Example 16 | $Sr_{1.005}Ba_{0.85}Eu_{0.025}Gd_{0.01}Li_{0.01}SiO_{3.9}\cdot0.3MgO$ | 82.7 | 77.6 | 64.1 |

**Claims**

1. A phosphor represented by a composition of the following formula (1),

$$(Sr_a,Ba_b,Ca_c,Eu_x,M^1_d,M^2_e)SiO_f\cdot gMgO \cdots \qquad \text{formula (1)}$$

(here, $M^1$ represents at least one group 3 element selected from Lu and Sc, $M^2$ represents an alkali metal element selected from Li, Na, and K, and $0 < a \le 2$, $0 < b \le 2$, $0 \le c \le 2$, $0.0015 \le d \le 0.045$, $0 \le e \le 0.06$, $0 < x \le 0.1$, $3.7 \le f \le 4.1$, and $0 \le g \le 1$ are satisfied).

2. The phosphor according to claim 1, wherein the x is within a range of $0.01 \le x \le 0.07$.

3. The phosphor according to claim 1 or 2, wherein the d is within a range of $0.002 \le d \le 0.04$.

4. The phosphor according to any one of claims 1 to 3, to be excited with light having a wavelength of 390 to 420 nm.

5. A light-emitting device comprising the phosphor according to any one of claims 1 to 4 and a light source for irradiating the phosphor with excitation light to cause the phosphor to emit light.

## INTERNATIONAL SEARCH REPORT

| International application No. |
| --- |
| PCT/JP2015/080994 |

| A. CLASSIFICATION OF SUBJECT MATTER |
| --- |
| C09K11/79(2006.01)i, C09K11/59(2006.01)i, H01L33/50(2010.01)i |

According to International Patent Classification (IPC) or to both national classification and IPC

| B. FIELDS SEARCHED |
| --- |

Minimum documentation searched (classification system followed by classification symbols)
C09K11/79, C09K11/59, H01L33/50

Documentation searched other than minimum documentation to the extent that such documents are included in the fields searched
Jitsuyo Shinan Koho          1922–1996   Jitsuyo Shinan Toroku Koho   1996–2015
Kokai Jitsuyo Shinan Koho    1971–2015   Toroku Jitsuyo Shinan Koho   1994–2015

Electronic data base consulted during the international search (name of data base and, where practicable, search terms used)
CAplus/REGISTRY(STN)

| C. DOCUMENTS CONSIDERED TO BE RELEVANT |
| --- |

| Category* | Citation of document, with indication, where appropriate, of the relevant passages | Relevant to claim No. |
| --- | --- | --- |
| X | CN 102286282 A (ChuangLian Electronic Component (Group)Co., Ltd.), 21 December 2011 (21.12.2011), claims; examples (Family: none) | 1-5 |
| X | CN 101851508 A (Jiangsu Bree Optronics Co., Ltd.), 06 October 2010 (06.10.2010), claims; examples (Family: none) | 1-5 |
| X | JP 2007-154122 A (Pioneer Corp. et al.), 21 June 2007 (21.06.2007), claims; examples; fig. 2 (Family: none) | 1-5 |

| ☒ Further documents are listed in the continuation of Box C. | ☐ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered    to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 20 November 2015 (20.11.15) | 01 December 2015 (01.12.15) |

| Name and mailing address of the ISA/ | Authorized officer |
| --- | --- |
| Japan Patent Office 3-4-3,Kasumigaseki,Chiyoda-ku, Tokyo 100-8915,Japan | |
| | Telephone No. |

Form PCT/ISA/210 (second sheet) (July 2009)

**INTERNATIONAL SEARCH REPORT**

International application No.

PCT/JP2015/080994

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2007-77307 A (Niigata University),<br>29 March 2007 (29.03.2007),<br>entire text<br>& US 2009/0159848 A1<br>entire text<br>& WO 2007/032465 A1     & CN 101263213 A | 1-5 |
| A | CN 101880528 A (Jiangxi University of Science<br>and Technology)<br>10 November 2010 (10.11.2010),<br>entire text<br>(Family: none) | 1-5 |
| A | Crystal structure and Photoluminescence of<br>$(Ba_{1-x-y}Sr_yEu_x)_9Sc_2Si_6O_{24}$, Jounal of<br>Luminescence, 132(2012), pp.2541-2545 | 1-5 |
| A | JP 2009-40944 A (Mitsubishi Chemical Corp.),<br>26 February 2009 (26.02.2009),<br>entire text<br>(Family: none) | 1-5 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008266410 A

- JP 2013136697 A